# EUROPÄISCHE PATENTSCHRIFT

(11) **EP 2 775 613 B1**
(45) Veröffentlichungstag und Bekanntmachung des Hinweises auf die Patenterteilung: **02.05.2018**
(21) Anmeldenummer: 14000745.1
(22) Anmeldetag: 03.03.2014
(51) Int. Cl.: H03F 3/58

(54) **Verfahren zum Betreiben eines Verstärkermoduls eines Satelliten**
Method for operating an amplifier module of a satellite
Procédé de fonctionnement d'un module d'amplification d'un satellite

(30) Priorität: 08.03.2013 DE 102013003903
(43) Veröffentlichungstag der Anmeldung: 10.09.2014
(73) Patentinhaber: Tesat-Spacecom GmbH & Co. KG, 71522 Backnang (DE)
(72) Erfinder: Reinwald, Gerhard, 71546 Aspach (DE); Katz, Hanspeter, 70374 Stuttgart (DE)
(74) Vertreter: LKGLOBAL Lorenz & Kopf PartG mbB Patentanwälte

(56) Entgegenhaltungen:
- EP-A2- 1 478 088
- US-A1- 2006 103 460
- US-A1- 2012 156 988

## Beschreibung

### GEBIET DER ERFINDUNG

Die Erfindung betrifft ein Verfahren zum Betreiben eines Verstärkermoduls eines Kommunikationssatelliten sowie ein Verstärkermodul.

### HINTERGRUND DER ERFINDUNG

Als Leistungsverstärker werden in Satelliten vornehmlich Wanderfeldröhrenverstärker (TWTA, Travelling Wave Tube Amplifier) eingesetzt, die in der Regel als Wanderfeldröhrenmodule ausgeführt sind. Diese umfassen eine Wanderfeldröhre, die vornehmlich die Hochfrequenz-Eigenschaften bestimmt und eine Stromversorgung, die die Versorgungsspannungen für die Wanderfeldröhre erzeugt, eine Telemetrie- und/oder Telekommando-Schnittstelle zum Satelliten, sowie eine Steuerung. Ergänzt werden kann das Wanderfeldröhrenmodul durch einen Vorverstärker (auch Kanalverstärker genannt), der auch einen Linearisierer beinhalten kann, der auch mit den anderen Komponenten in einem Gehäuse integriert sein kann. In dieser Kombination spricht man dann von einem Hochfrequenz-Leistungsmodul.

In einer Wanderfeldröhre wird ein Hochfrequenzsignal dadurch verstärkt, dass ein Elektronenstrahl an einem in der Regel wendelförmigen Leiter vorbeigeführt wird, durch den das Hochfrequenzsignal fließt. Bei geeigneter Auslegung des Leiters und des Elektronenstrahls kann dabei Energie von dem Elektronenstrahl auf das Hochfrequenzsignal übertragen werden.

Wanderfeldröhrenmodule und im Allgemeinen Verstärkermodule werden im Allgemeinen so gebaut, dass Geräte vom gleichen Typ untereinander austauschbar sind, sodass ein Anwender diese beliebig auf dem Satelliten platzieren kann. Insbesondere kann ein Satellit eine Mehrzahl von gleichartig aufgebauten Wanderfeldröhrenmodulen aufweisen, die jeweils einem Kanal des Satelliten zugeordnet sind und die dazu genutzt werden, das Hochfrequenzsignal des jeweiligen Kanals zu verstärken.

Dabei wird in Kauf genommen, dass die Eigenschaften der individuellen Kanäle nicht berücksichtigt werden. Nach dem Einschalten der Verstärkermodule können diese dann per Telekommando (d.h. mittels eines Kommandos von einer Bodenstation) auf die Kanaleigenschaften bzw. Art des Betriebs konfiguriert werden. Dies muss nach jedem Einschalten neu erfolgen.

US 2006/0103460 A1 beschreibt ein Leistungssteuerungssystem für einen Satelliten, welcher für Funkübertragung ausgeführt ist. Ein Leistungsverstärker enthält Speicherbausteine zum Abspeichern von Konfigurationsparametern.

EP 1 478 088 A2 beschreibt einen Hochleistungsverstärker für Satelliten. Es ist vorgesehen, dass während einer Testphase am Boden mehrere verschiedene Konfigurationssets in einer Tabelle bereitgestellt werden, welche während der Betriebsphase im Orbit wahlweise ausgelesen und appliziert werden können.

### ZUSAMMENFASSUNG DER ERFINDUNG

Es ist Aufgabe der Erfindung, ein leicht zu konfigurierendes Verstärkermodul bereitzustellen.

Diese Aufgabe wird durch den Gegenstand der unabhängigen Ansprüche gelöst. Weitere Ausführungsformen der Erfindung ergeben sich aus den abhängigen Ansprüchen und aus der folgenden Beschreibung.

Ein Aspekt der Erfindung betrifft ein Verfahren zum Betreiben eines Verstärkermoduls eines Kommunikationssatelliten.

Das Verstärkermodul kann eine Verstärkereinheit und eine Steuerung zum Ansteuern der Verstärkereinheit umfassen. Es ist zu verstehen, dass der Kommunikationssatellit eine Mehrzahl von Verstärkermodulen aufweisen kann, die jeweils einem Kanal des Satelliten zugeordnet sein können.

Das Verstärkermodul kann ein Wanderfeldröhrenmodul sein, bei dem die Verstärkung durch eine Wanderfeldröhre stattfindet. Es ist aber auch möglich, dass das Verstärkermodul ein Halbleiterverstärkermodul mit einem Halbleiterverstärker ist.

Gemäß der Erfindung umfasst das Verfahren die Schritte: Abspeichern einer Mehrzahl von Konfigurationsparametern des Verstärkermoduls in einem nichtflüchtigen Speicher, der dazu ausgeführt ist, die Mehrzahl von Konfigurationsparametern zu speichern, wenn das Verstärkermodul nicht bestromt ist; Nach einem Bestromen des Verstärkermoduls, Laden der Mehrzahl von Konfigurationsparametern aus dem nicht-flüchtigen (Daten-)Speicher; und Konfigurieren des Verstärkermoduls entsprechend der geladenen Mehrzahl von Konfigurationsparametern, Überprüfen, ob die Mehrzahl von Konfigurationsparametern während der Betriebszeit des Verstärkermoduls, wobei die Mehrzahl von Konfigurationsparametern vor einem Abschalten des Verstärkermoduls automatisch in dem nichtflüchtigen Speicher abgespeichert wird, wenn eine Änderung festgestellt wurde, wobei die Mehrzahl von Konfigurationsparametern eine Linearisierungskurve eines Linearisierers des Verstärkermoduls beschreibt, wobei die Mehrzahl von Konfigurationsparametern des Verstärkermoduls in einem Konfigurationsparameterset abgespeichert wird, wobei ein Konfigurationsparameterset abgespeichert und nur als Set abgerufen werden kann.

Unter dem Bestromen des Verstärkermoduls kann dabei ein Einschalten des Verstärkermoduls verstanden werden, bei dem die Schaltkreise des Verstärkermoduls, wie etwa der eines Vorverstärker/Linearisierer eines Wanderfeldröhrenmoduls unter Strom gesetzt werden können.

Der nicht-flüchtige Speicher ist in der Regel dazu ausgeführt, den Umweltbedingungen im Weltraum standzuhalten, d.h., der nicht-flüchtige Speicher kann resistent gegenüber Temperaturschwankungen in einem großen Bereich und/oder resistent gegenüber Strahlung sein. Die Umweltbedingungen, denen ein Satellit im Betrieb ausgesetzt ist, halten den Fachmann davon ab, eine Vielzahl von elektronischen Komponenten zu verbauen, die nicht, oder nur schwer auszutauschen sind, wenn sich der Satellit im Orbit befindet.

In der Regel wird der nicht-flüchtige Speicher dazu ausgeführt sein, eine Mehrzahl von Konfigurationsparametern zwischenzuspeichern, wenn das Verstärkermodul nicht bestromt ist, beispielsweise, wenn es von einer Hauptsteuerung des Satelliten von der Stromversorgung des Satelliten getrennt wurde.

Ein Konfigurationsparameter kann dabei im Allgemeinen ein Datenwert sein, der von einer Steuerung des Verstärkermoduls dazu verwendet werden kann, sich selbst und/oder andere Komponenten des Verstärkermoduls, wie etwa eine Reglereinheit und/oder eine Verstärkereinheit, zu konfigurieren bzw. einzustellen.

Insbesondere können Einstellungen (d.h. Konfigurationsparameter), die vom Betreiber des Satelliten vorgenommen wurden, abgespeichert und diese beim Einschalten aufgerufen werden, sodass das Verstärkermodul sich sofort in der gewünschten Konfiguration befindet.

Beispielsweise kann der nichtflüchtige Speicher ausgelesen und ein ausgelesener Wert in ein Register übertragen werden. Änderungen in diesem Register können dann entweder automatisch oder auf Befehl in den nichtflüchtigen Speicher zurück geschrieben werden. Auch wenn Änderungen direkt im nichtflüchtigen Speicher vorgenommen werden ist es möglich, dass diese dann automatisch und/oder per Befehl in das Register übernommen werden.

Das Abspeichern von Konfigurationsparametern in einem nicht-flüchtigen Speicher kann die folgenden Vorteile haben:
Der Betreiber des Satelliten kann bei Satellitentests am Boden die individuellen Verstärkermodule optimieren, beispielsweise eine Ausgangsleistung auf einen im vorgesehenen Kanal gebrauchten Wert einstellen, bzw. einen Kanalverstärker und/oder Linearisierer konfigurieren. Im Orbit befindet sich das Verstärkermodul sofort nach dem Einschalten im optimalen Zustand und muss nicht erst über verschiedene Telekommandos eingestellt werden.

Weiter kann es vorkommen, dass das Verstärkermodul im Orbit aufgrund einer Schutzschaltung abschaltet bzw. aus betrieblichen Gründen per Telekommando ausgeschaltet wird. Nach dem Wiedereinschalten kann sich das Verstärkermodul in genau dem Zustand wie vor dem Ausschalten befinden und muss nicht neu eingestellt werden.

Gemäß einer Ausführungsform der Erfindung umfasst das Verfahren weiter die Schritte von: Trennen des Verstärkermoduls von einer Stromversorgung des Satelliten, nachdem die Mehrzahl von Konfigurationsparametern gespeichert wurde; und Verbinden des Verstärkermoduls mit der Stromversorgung vor dem Laden der Mehrzahl von Konfigurationsparametern. Wie gesagt können diese Schritte von einer Hauptsteuerung bzw. einer Steuerung außerhalb des Verstärkermoduls ausgeführt werden, beispielsweise durch eine Schutzschaltung und/oder durch ein Telekommando, das beispielsweise von einer Bodenstation an den Satelliten gesendet werden kann.

Gemäß der Erfindung umfasst das Verfahren weiter den Schritt von: Überprüfen, ob die Mehrzahl von Konfigurationsparametern geändert wurde, wobei die Mehrzahl von Konfigurationsparametern automatisch in dem nicht-flüchtigen Speicher abgespeichert wird, wenn eine Änderung festgestellt wurde. Beispielsweise kann eine Softwarefunktion der Steuerung bestimmte Speicherbereiche eines flüchtigen Speichers der Steuerung überwachen und immer dann, wenn diese geändert werden, die Änderungen sofort in den nicht-flüchtigen Speicher übernehmen. Immer dann, wenn die Konfiguration bzw. bestimmte Konfigurationsparameter geändert werden, werden die neue Konfiguration bzw. die geänderten Konfigurationsparameter automatisch in dem nicht-flüchtigen Speicher abgespeichert.

Es ist auch möglich, dass die aktuelle Konfiguration bzw. der oder die Konfigurationsparameter vor dem Abschalten automatisch in den nichtflüchtigen Speicher übernommen wird, unabhängig davon, ob eine Änderung vorgenommen wurde oder nicht.

Es ist auch möglich, dass alle oder nur ein Teil der Konfigurationsparameter automatisch abgespeichert werden. Möchte der Betreiber des Satelliten bestimmte Konfigurationsparameter, unabhängig von der aktuellen Einstellung bzw. Konfiguration, nach dem Einschalten immer in einer gewissen Einstellung haben, so kann das Abspeichern der aktuellen Einstellung dieser Parameter unterdrückt werden.

Gemäß einer Ausführungsform der Erfindung umfasst das Verfahren weiter den Schritt von: Empfang eines Telekommandos, dass ein Konfigurationsparameter gespeichert werden soll; wobei der Konfigurationsparameter in dem nichtflüchtigen Speicher abgespeichert wird, wenn das Telekommando empfangen wurde. Auf diese Weise können Konfigurationsparameter nur einmal von der Bodenstation aus geändert werden und stehen dann auch nach einem Neustart des Verstärkermoduls zur Verfügung.

Die aktuelle Einstellung bzw. die Konfigurationsparameter müssen nicht automatisch, sondern können erst nach einem entsprechenden (Tele-)Kommando abgespeichert werden. Bei einem entsprechenden Speicherkommando können die Konfigurationsparameter in den nicht-flüchtigen Speicher geladen und können von dort wieder abgerufen werden. Dies kann den Vorteil haben, dass das Verstärkermodul, wenn vom Betreiber des Satelliten gewünscht, immer im gleichen Aufwachzustand einschaltet, aber danach ohne umfangreichen Konfigurationsprozess in den gewünschten Betriebszustand versetzt werden kann.

Gemäß einer Ausführungsform der Erfindung wird zum Abspeichern der Konfigurationsparameter ein Konfigurationsbereich aus einem flüchtigen Speicher des Verstärkermoduls in den nicht-flüchtigen Speicher übertragen bzw. kopiert. Zum Laden der Konfigurationsparameter kann ein Inhalt des nicht-flüchtigen Speichers in den Konfigurationsbereich übertragen bzw. kopiert werden. Auf diese Weise können eine Vielzahl von Konfigurationsparametern gleichzeitig gespeichert und gesetzt werden.

Gemäß einer Ausführungsform der Erfindung umfasst das Verfahren weiter den Schritt von: Festlegen, dass wenigstens ein bestimmter Konfigurationsparameter aus dem Konfigurationsbereich nicht in den nicht-flüchtigen Speicher übertragen bzw. kopiert wird, um ein Überschreiben des Konfigurationsparameters im nichtflüchtigen Speicher zu verhindern.

Gemäß einer Ausführungsform der Erfindung ist die Mehrzahl von Konfigurationsparametern eine Einstellung einer Reglereinheit, der dazu ausgeführt ist, eine Spannung einer Wanderfeldröhre eines Wanderfeldröhrenmoduls zu regeln; einer Kathodenspannung der Wanderfeldröhre; einer Wehneltspannung der Wanderfeldröhre; einer Anodenspannung der Wanderfeldröhre; ein oder mehrerer Kollektorspannungen oder einer sonstigen Betriebsgröße der Wanderfeldröhre. Alle oder bestimmte Regelparameter der Wanderfeldröhre können im nicht-flüchtigen Speicher zwischengespeichert werden, um so die Wanderfeldröhre nach einem Abschalten wieder in der gleichen Konfiguration betreiben zu können, ohne dass die Einstellungen erneut vorgenommen werden müssen.

Gemäß der Erfindung umfasst das Verfahren weiter den Schritt von Abspeichern eines Konfigurationsparametersets des Verstärkermoduls in dem nicht-flüchtigen Speicher. Es ist nicht nur möglich, dass einzelne Konfigurationsparameter abgespeichert werden sondern es können auch alternativ oder zusätzlich Gruppen bzw. Sets von Konfigurationsparametern abgespeichert werden bzw. Information, die diese Sets betreffen. Die Einstellungen der Spannungen und Ströme können in Parametersets zusammengefasst sein, die nur als Set abgerufen werden können, beispielsweise je nachdem in welchem Frequenzbereich das Verstärkermodul betrieben werden soll. Der Nutzer Kann ein Set zwischen 1 bis n als abzuspeicherndes Set auswählen. Die Information (d.h. beispielsweise eine Zahl zwischen 1 bis n) welches Parameterset zum Abspeichern ausgewählt ist, kann auch im nichtflüchtigen Speicher gespeichert werden. Darüber hinaus können dann weitere, zusätzliche Einstellungen bzw. Konfigurationsparameter, beispielsweise der Ausgangsleistung, vorgenommen und abgespeichert werden.

Als Konfiguration kann ein Parameterset ausgewählt werden, beispielsweise aus verschiedenen Spannungen und/oder Strömen. Darüber hinaus können noch einzelne Konfigurationsparameter gespeichert werden um beispielsweise die Ausgangsleistung über die Anodenspannung und/oder Kathodenstrom einzustellen. Eine Konfiguration kann ein Set von Betriebsparametern und/oder die Einstellung einzelner darin enthaltener Parameter umfassen.

Wenn zum Beispiel ein Verstärker in einem bestimmten Frequenzband betrieben werden soll. gehört hierzu Beispielsweise ein Parameterset mit einer bestimmten Nummer (wie etwa Nr. 2). Von diesem Parameterset können die Anodenspannung/Kathodenstrom in bestimmten Schritten geändert werden, um die Ausgangsleistung einstellen zu können beispielsweise auf einen Level 18. Als Konfiguration könnte hier also abgelegt werden: Set Nr.2, Ausgangsleistung Level 18.

Gleiches gilt gemäß der Erfindung für Konfigurationsparametersets eines Vorverstärkers/Linearisierers. Auch hier könnte passende Set an Betriebsparametern ausgewählt werden (wie etwa. Nr 2), das unter anderem die zu dem Frequenzband passende Einstellung des Linearisierers und/oder eine Grundverstärkung umfassen kann. Geändert werden kann beispielsweise der Betriebsmodus (FGM, ALC), die Pegel (Verstärkung in FGM, Leistung im ALC) und/oder auch Mute on oder off. Die Konfiguration, die abgelegt wird, kann also die Nummer des Parametersets zusammen mit den Zuständen der zu verändernden Parameter umfassen.

Gemäß der Erfindung wird eine Linearisierungskurve eines Linearisierers eines Wanderfeldröhrenmöduls als eine Mehrzahl von Konfigurationsparametern abgespeichert. Ein Wanderfeldröhrenmodul kann einen Linearisier umfassen, d.h. einen Verstärker, der dazu ausgeführt ist, ein nicht-lineares Verstärkungsverhalten der Wanderfeldröhre auszugleichen, dazu kann für den Linearisierer eine Linearisierungskurve gespeichert sein, anhand derer der Linearisierer das der Wanderfeldröhre zugeführte Hochfrequenzsignal nicht-linear verstärkt. Diese Linearisierungskurve kann beispielsweise abhängig vom Frequenzbereich modifiziert werden und die Änderungen können im nicht-flüchtigen Speicher zwischengespeichert werden. Neben der reinen Linearisierungskurve bzw. Linearisiererkennlinie können auch Konfigurationsparameter für die Verstärkung und den Frequenzgang abgespeichert werden.

Der Linearisierer kann auch mit einem Vorverstärker kombiniert sein, oder es kann sich um einen reinen Vorverstärker ohne einen Linearisierer handeln. Es können auch die Verstärkung und/oder der Frequenzgang eines Equalizers abgespeichert werden. Auch hier können die Einstellungen für den Linearisierer/Vorverstärker in 1 bis n Parametersets zusammengefasst und diese entsprechend der Anwendung abgerufen bzw. abgespeichert werden. Als Konfigurationsparameter kann abgespeichert werden, welches Set gerade ausgewählt ist. Darüber hinaus können noch weitere Einstellungen abgespeichert werden, beispielsweise. verschiedene Moden, z.B. Fixed Gain Mode (FGM) oder Automatic Level Control (ALC), verschiedene Verstärkung (im FGM) bzw. verschiedene Ausgangsleistung (im ALC) die auch als Konfiguration abgespeichert werden können.

Ein weiterer Aspekt der Erfindung betrifft ein Verstärkermodul für einen Kommunikationssatelliten. Ein Modul kann beispielsweise eine Baugruppe mit einem gemeinsamen Gehäuse oder einem gemeinsamen Trägerelement sein, an dem die Komponenten des Verstärkermoduls befestigt sind und/oder mit dem die Komponenten des Verstärkermoduls, wie etwa eine Steuerung, Reglereinheiten, die Verstärkereinheit, wie etwa eine Wanderfeldröhre oder ein Halbleiterverstärker usw., gemeinsam im Satelliten verbaut werden können.

Gemäß einer Ausführungsform der Erfindung umfasst das Verstärkermodul eine Verstärkereinheit und eine Steuerung zum Ansteuern der Verstärkereinheit.

Die Verstärkereinheit kann eine Wanderfeldröhre sein. Die Wanderfeldröhre kann beispielsweise umfassen: einen Emitter, der dazu ausgeführt ist, bei Anlegen einer Spannung einen Elektronenstrahl zu erzeugen; einen Verstärkerabschnitt, der von dem Elektronenstrahl durchlaufen wird, in dem ein Leiter angeordnet ist, und in dem ein den Leiter durchlaufendes Hochfrequenzsignal durch den Elektronenstrahl verstärkbar ist; und einen Kollektor, der dazu ausgeführt ist, den Elektronenstrahl aufzunehmen und an den Emitter zurückzuführen.

Weiter umfasst die Steuerung einen nicht-flüchtigen, beschreibbaren Speicher, der dazu ausgeführt ist, wenigstens einen Konfigurationsparameter des Verstärkermoduls zu speichern, wenn das Verstärkermodul nicht von einer externen Stromversorgung bestromt ist. Der nicht-flüchtige Speicher kann beispielsweise in einem besonderen Chip vorgesehen sein, der separat von der Elektronik der Steuerung im Verstärkermodul verbaut sein kann.

Gemäß einer Ausführungsform der Erfindung umfasst die Steuerung einen flüchtigen Speicher. Es ist möglich, dass das Verstärkermodul einen weiteren Speicher umfasst, dessen Inhalt gelöscht wird, wenn das Verstärkermodul von der Stromversorgung getrennt wird.

Gemäß einer Ausführungsform der Erfindung umfasst das Verstärkermodul weiter eine Hilfsspannungsversorgung, die dazu ausgeführt ist, den nicht-flüchtigen Speicher mit Energie zu versorgen, wenn das Verstärkermodul nicht von einer externen Stromversorgung bestromt ist. Beispielsweise kann die Hilfsspannungsversorgung einen Kondensator oder eine Batterie umfassen, der oder die von der Stromversorgung geladen wird, wenn das Verstärkermodul mit der Stromversorgung verbunden ist.

Es kann aber auch sein, dass die Hilfsspannungsversorgung lediglich dazu dient, im Betrieb interne Versorgungsspannungen zu erzeugen. In diesem Fall ist es möglich, dass alle Schaltkreise des Verstärkermoduls im unbestromten Zustand, d.h. wenn es abgeschaltet ist, spannungsfrei sind.

Gemäß einer Ausführungsform der Erfindung umfasst das Verstärkermodul weiter eine Telekommandoschnittstelle, die dazu ausgeführt ist, ein Telekommando zu empfangen, das ein Abspeichern des oder der Konfigurationsparameter im nichtflüchtigen Speicher auslöst. Beispielsweise kann diese Telekommandoschnittstelle eine externe Schnittstelle des Verstärkermoduls sein, mit dem das Verstärkermodul mit einer weiteren Steuerung des Satelliten kommunizieren kann.

Gemäß einer Ausführungsform der Erfindung umfasst das Verstärkermodul weiter wenigstens eine Reglereinheit, die dazu ausgeführt ist, die Verstärkereinheit anzusteuern. Mit der Reglereinheit können beispielsweise eine oder mehrere Kollektorspannungen, Anodenspannung, Kathodenspannung und /oder sonstige Betriebsgrößen geregelt werden. Die Steuerung ist dazu ausgeführt, einen Konfigurationsparameter der Reglereinheit auszulesen und diesen Konfigurationsparameter in dem nicht-flüchtigen Speicher zu speichern und/oder den Konfigurationsparameter aus dem nicht-flüchtigen Speicher auszulesen und in der Reglereinheit entsprechend zu setzen.

Auch hier ist es möglich, dass die Einstellungen der Regler für die verschiedenen Spannungen in Parametersets abgelegt sind und mit der Konfiguration nur ausgewählt wird, welches Set gerade benutzt wird. Mit anderen Worten kann die Auswahl des aktuellen Parametersets ein Konfigurationsparameter sein, der im nicht-flüchtigen Speicher abgelegt wird.

Gemäß der Erfindung ist die Steuerung dazu ausgeführt, das Verfahren zum Betreiben des Verstärkermoduls, so wie obenstehend und untenstehend beschrieben, auszuführen. Es ist zu verstehen, dass Merkmale des Verstärkermoduls auch Merkmale des Verfahrens sein können und umgekehrt.

Insgesamt können der nicht-flüchtiger Speicher und/oder die Steuerung in der Stromversorgung des Verstärkermoduls untergebracht sein. Der nicht-flüchtiger Speicher und/oder die Steuerung können auch im Vorverstärker und/oder Linearisierer, oder aber auch ein Teil in der Stromversorgung und der andere im Vorverstärker und/oder Linearisierer untergebracht sein.

Weiter ist möglich, dass bei einem Wanderfeldröhrenmodul zwei Wanderfeldröhren von einer Stromversorgung versorgt werden und eventuell einen gemeinsamen Vorverstärker oder jede Wanderfeldröhre individuell einen Vorverstärker aufweist.

Im Folgenden werden Ausführungsbeispiele der Erfindung mit Bezug auf die beiliegenden Figuren detailliert beschrieben.

### KURZE BESCHREIBUNG DER FIGUREN

Fig. 1 zeigt eine schematische Ansicht eines Kommunikationssatelliten gemäß einer Ausführungsform der Erfindung.
Fig. 2 zeigt eine schematische Ansicht eines Verstärkermoduls gemäß einer Ausführungsform der Erfindung.
Fig. 3 zeigt ein Flussdiagramm für ein Verfahren zum Betreiben eines Verstärkermoduls gemäß einer Ausführungsform der Erfindung.

Grundsätzlich sind identische oder ähnliche Teile mit den gleichen Bezugszeichen versehen.

### DETAILLIERTE BESCHREIBUNG VON AUSFÜHRUNGSBEISPIELEN

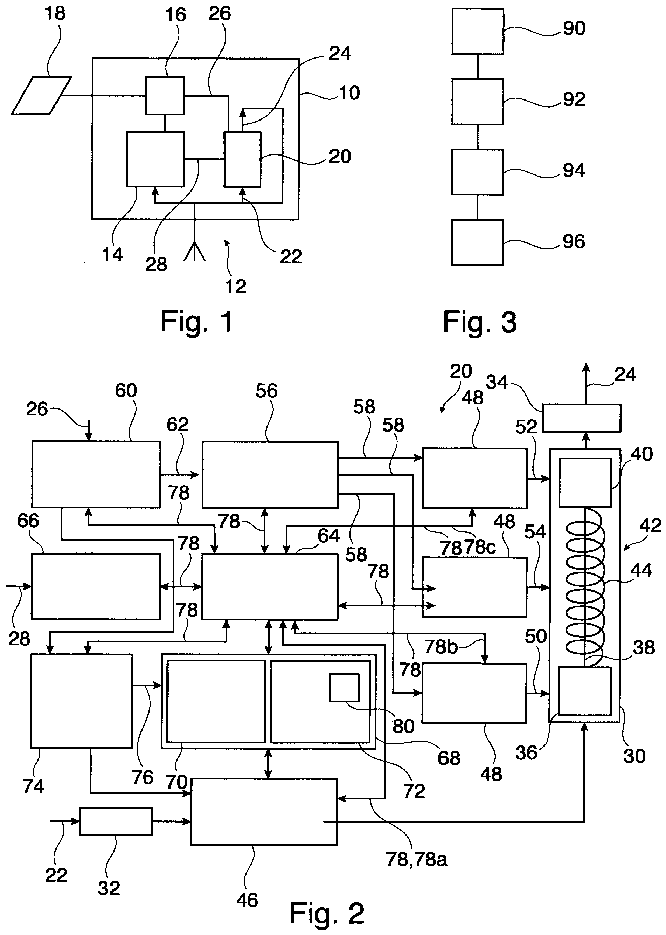

Fig. 1 zeigt einen Kommunikationssatelliten 10 mit einer Antenne 12, einer Hauptsteuereinheit bzw. Hauptsteuerung 14 und einer Stromversorgung 16, die beispielsweise von einem Sonnenpanel 18 mit Energie versorgt wird.

Weiter weist der Kommunikationssatellit 10 ein Verstärkermodul 20 in der Form eines Wanderfeldröhrenmoduls 20 auf. In der Fig. 1 ist lediglich ein Kanal des Kommunikationssatelliten 10 dargestellt, in der Regel kann ein Kommunikationssatellit 10 mehrere Kanäle aufweisen, die jeweils ein Wanderfeldröhrenmodul 20 umfassen können.

Über die Antenne 12 kann der Kommunikationssatellit 10 ein Hochfrequenzsignal 22 empfangen und an das Wanderfeldröhrenmodul 20 weiterleiten. Dort wird das Hochfrequenzsignal 22 zu einem verstärkten Hochfrequenzsignal 24 verstärkt und kann wieder über die Antenne 12 (oder eine weitere Antenne) abgestrahlt werden. Über die Stromversorgung 16 wird das Wanderfeldröhrenmodul 20 dabei mit Strom 26 versorgt. Weiter kann das Wanderfeldröhrenmodul 20 von der Steuereinheit 14 angesteuert werden und beispielsweise Telekommandos 28 empfangen, die beispielsweise über die Antenne 12 empfangen und von der Steuereinheit 14 ausgewertet wurden.

Mit diesen Telekommandos und/oder mit einer Schutzschaltung der Steuerung 14 kann das Wanderfeldröhrenmodul von der Stromversorgung 16 getrennt und wieder mit dieser verbunden werden.

Die Fig. 2 zeigt ein Wanderfeldröhrenmodul 20 detaillierter. Das Wanderfeldröhrenmodul 20 umfasst eine Wanderfeldröhre 30, die über einen Hochfrequenzeingang 32 das Hochfrequenzsignal 22 empfängt und das verstärkte Hochfrequenzsignal 24 über einen Hochfrequenzausgang 34 ausgibt.

Die Wanderfeldröhre 30 umfasst einen Emitter 36, mit dem ein Elektronenstrahl 38 erzeugt werden kann und einen Kollektor 40, der den Elektronenstrahl 38 wieder aufnimmt. Auf diese Weise kann der elektrische Strom aus dem Elektronenstrahl 38 wieder zum Emitter 36 zurückgeführt werden. Zwischen dem Emitter und dem Kollektor 38 liegt ein Verstärkerbereich 42, in dem das Hochfrequenzsignal 22 durch den Elektronenstrahl 38 verstärkt wird. Das Hochfrequenzsignal 22 wird dabei durch einen Leiter 44 durch die Wanderfeldröhre 30 geschickt.

Zwischen dem Hochfrequenzeingang 32 und der Wanderfeldröhre 30 kann das Wanderfeldröhrenmodul 20 einen Kanalverstärker und/oder Linearisierer 46 aufweisen, mit dem das unverstärkte Hochfrequenzsignal 22 vorverstärkt und/oder linearisiert werden kann, bevor es der Wanderfeldröhre 30 zugeführt wird.

Die Wanderfeldröhre 30 wird von einer Mehrzahl von Sekundärreglern bzw. Reglereinheiten 48 angesteuert, die beispielsweise eine Anodenspannung 50, eine oder mehrere Kollektorspannungen 52, und Kathodenspannung des Emitters und weitere einstellbare Spannungen bzw. betriebsgrößen 54 der Wanderfeldröhre 30 einstellen und/oder regeln können.

Die Sekundärregler 48 werden von einer Hochspannungserzeugung 56 mit einer Hochspannung 58 versorgt, die von einem Vorregler und Filter 60 mit Strom bzw. Spannung 62 versorgt wird. Der Vorregler und Filter 60 wandelt den Strom 26 aus der Stromversorgung 16 des Satelliten 10 zu einem konstanten und gleichmäßigen Gleichstrom 62 um.

Das Wanderfeldröhrenmodul 20 umfasst außerdem eine elektronische Steuerung 64, die die Reglereinheiten 48 und den Kanalverstärker und/oder Linearisierer 46 einstellen und ansteuern kann. Bei der Einheit 46r kann es sich auch um einen reinen Vorverstärker oder eine Kombination von einem Verstärker und Linearisierer handeln. Weiter kann das Wanderfeldröhrenmodul 20 eine Telekommando-Schnittstelle 66 umfassen, die Telekommandos 28 für die Steuerung 64 vorverarbeiten kann.

Die Steuerung 64 umfasst einen Speicherbaustein 68, der einen nicht-flüchtigen Speicher bzw. Festwertspeicher 70 und einen flüchtigen Speicher 72 umfasst.

Der Speicherbaustein 68 bzw. zumindest der nicht-flüchtige Speicher 70 kann von einer Hilfsspannungsversorgung 74 mit Strom 76 versorgt werden, die mit dem Vorregler und Filter 60 verbunden ist. Die Hilfsspannungsversorgung 74 kann eine Batterie oder einen Kondensator umfassen, die oder der geladen werden können, wenn das Wanderfeldröhrenmodul 20 mit der Stromversorgung 16 verbunden ist.

Es ist aber auch möglich, dass der nicht-flüchtige Speicher 70 in der Lage ist, unbestromt Daten zu speichern, wie etwa ein FLASH-Speicher.

Um das Wanderfeldröhrenmodul 20 zu steuern, kann die Steuerung 64 bestimmte Konfigurationsparameter, Stellgrößen bzw. Einstellungen 78 der Komponenten 46, 48, 56, 60, 66, 74 einstellen und/oder Konfigurationsparameter 78 an diese Komponenten versenden und/oder Konfigurationsparameter aus diesen Komponenten auslesen.

Beispielsweise kann die Steuerung 64 die Werte 78a einer Linearisierungskurve des Linearisierers 46 und/oder den Sollwert 78 für die Kathodenspannung 54 und/oder den Sollwert 78b für die Kollektorspannung 52 setzen.

Die Konfigurationsparameter 78 können dann von der Steuerung 64 automatisch und/oder auf Kommando in dem nicht-flüchtigen Speicher gespeichert werden. Beispielsweise umfasst der flüchtige Speicher 72 einen Konfigurationsspeicherbereich 80, der beispielsweise automatisch mit dem nicht-flüchtigen Speicher 70 abgeglichen werden kann.

Die Fig. 3 zeigt ein Flussdiagramm, mit dem das Wanderfeldröhrenmodul 20 betrieben werden kann.

Im Schritt 90 wird wenigstens einer der Konfigurationsparameter 78 des Wanderfeldröhrenmoduls 20 in dem nicht-flüchtigen Speicher 70 gespeichert. Dies kann bereits am Boden und/oder aber auch im Orbit geschehen. Das Speichern kann durch ein Telekommando 28 ausgelöst werden und/oder kann automatisch durch die Steuerung 64 erfolgen.

Im Schritt 92 wird das Wanderfeldröhrenmodul 20 von der Stromversorgung 16 des Satelliten 10 getrennt. Beispielsweise kann ein entsprechendes Telekommando 28 die Hauptsteuerung 14 des Satelliten 10 dazu veranlassen, das Wanderfeldröhrenmodul 20 abzuschalten. Auch ist es möglich, dass das Wanderfeldröhrenmodul 20 durch eine Schutzschaltung abgeschaltet wird.

Im Schritt 94 wird das Wanderfeldröhrenmodul 20 wieder mit der Stromversorgung 16 verbunden. Beispielsweise erhält die Hauptsteuerung 14 des Satelliten 10 wieder ein entsprechendes Telekommando und bestromt das Wanderfeldröhrenmodul 20 wieder.

Im Schritt 96 wird der Konfigurationsparameter 78 durch die Steuerung 64 aus dem nicht-flüchtigen Speicher 70 geladen und das Wanderfeldröhrenmodul 20 entsprechend dem geladenen Konfigurationsparameter 78 konfiguriert. Wenn beispielsweise die Steuerung 64 erkennt, dass das Wanderfeldröhrenmodul 20 wieder eingeschaltet bzw. bestromt worden ist, kann von der Steuerung 64 eine Startsequenz ausgeführt werden, in der die im nicht-flüchtigen Speicher 70 gespeicherten Konfigurationsparameter 78 wieder für das Wanderfeldröhrenmodul 20 gesetzt werden. Beispielsweise kann die Steuerung die Sollwerte 78a, 78b für Anodenspannung 50 und die Kollektorspannung 52 wieder auf die Werte setzen, die vor dem Abschalten des Wanderfeldröhrenmoduls 20 eingestellt waren.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Betreiben eines Verstärkermoduls (20) eines Kommunikationssatelliten (10), das Verfahren umfassend die Schritte:
Abspeichern einer Mehrzahl von Konfigurationsparametern (78) des Verstärkermoduls (20) in einem nicht-flüchtigen Speicher (70), der dazu ausgeführt ist, die Mehrzahl von Konfigurationsparametern (78) zu speichern, wenn das Verstärkermodul (20) nicht bestromt ist;
Nach einem Bestromen des Verstärkermoduls (20), Laden der Mehrzahl von Konfigurationsparametern (78) aus dem nicht-flüchtigen Speicher (70);
Konfigurieren des Verstärkermoduls (20) entsprechend der geladenen Mehrzahl von Konfigurationsparametern (78);
Überprüfen, ob die Mehrzahl von Konfigurationsparametern (78) während der Betriebszeit des Verstärkermoduls im Orbit geändert wird, wobei die Mehrzahl von Konfigurationsparametern (78) vor einem Abschalten des Verstärkermoduls automatisch in dem nicht-flüchtigen Speicher (70) abgespeichert wird, wenn eine Änderung festgestellt wurde;
wobei ein Teil der Mehrzahl von Konfigurationsparametern (78) eine Linearisierungskurve eines Linearisierers des Verstärkermoduls (20) beschreibt;
wobei die Mehrzahl von Konfigurationsparametern (78) des Verstärkermoduls in einem Konfigurationsparameterset abgespeichert wird, wobei ein Konfigurationsparameterset abgespeichert und nur als Set abgerufen werden kann.

2. Verfahren nach Anspruch 1, weiter umfassend die Schritte:
Trennen des Verstärkermoduls (20) von einer Stromversorgung (16) des Satelliten (10), nachdem die Mehrzahl von Konfigurationsparametern (78) gespeichert wurde;
Verbinden des Verstärkermoduls (20) mit der Stromversorgung (16) vor dem Laden der Mehrzahl von Konfigurationsparametern (78).

3. Verfahren nach einem der vorhergehenden Ansprüche, weiter umfassend den Schritt:
Empfang eines Telekommandos (28), dass die Mehrzahl von Konfigurationsparametern (78) gespeichert werden soll;
wobei die Mehrzahl von Konfigurationsparametern (78) in dem nichtflüchtigen Speicher (70) abgespeichert wird, wenn das Telekommando (28) empfangen wurde.

4. Verfahren nach einem der vorhergehenden Ansprüche,
wobei zum Abspeichern der Mehrzahl von Konfigurationsparametern (78) ein Konfigurationsbereich (80) aus einem flüchtigen Speicher (72) des Verstärkermoduls (20) in den nicht-flüchtigen Speicher (70) übertragen wird;
wobei zum Laden der Mehrzahl von Konfigurationsparametern (78) ein Inhalt des nicht-flüchtigen Speichers (70) in den Konfigurationsbereich (80) übertragenwird.

5. Verfahren nach Anspruch 4, weiter umfassend den Schritt:
Festlegen, dass wenigstens ein bestimmter Konfigurationsparameter (78) aus dem Konfigurationsbereich (80) nicht in den nicht-flüchtigen Speicher (70) übertragen wird, um ein Überschreiben des Konfigurationsparameters (78) im nicht-flüchtigen Speicher (70) zu verhindern.

6. Verfahren nach einem der vorhergehenden Ansprüche,
wobei die Mehrzahl von Konfigurationsparametern (78) neben der Linearisierungskurve eine Auswahl aus folgenden Parametern aufweist:
einer Einstellung einer Reglereinheit (48), die dazu ausgeführt ist, eine Spannung (50, 52, 54) einer Wanderfeldröhre (30) eines Wanderfeldröhrenmoduls (20) zu regeln;
einem Wert einer Kathodenspannung der Wanderfeldröhre (30);
einem Wert einer Wehneltspannung der Wanderfeldröhre (30);
einem Wert (78b) einer Anodenspannung (50) der Wanderfeldröhre (30);
einem Wert (78c) einer oder mehrerer Kollektorspannungen (52) der Wanderfeldröhre (30).

7. Verfahren nach einem der vorhergehenden Ansprüche,
wobei eine Linearisierungskurve (78a) eines Linearisierers (46) eines Wanderfeldröhrenmoduls (20) als Teil der Mehrzahl von Konfigurationsparametern (78) abgespeichert wird.

8. Verstärkermodul (20) für einen Kommunikationssatelliten (10), umfassend:
eine Verstärkereinheit (30);
einen Linearisierer; und
eine Steuerung (64) zum Ansteuern der Verstärkereinheit (30);
wobei die Steuerung (64) einen nicht-flüchtigen, beschreibbaren Speicher (70) umfasst, der dazu ausgeführt ist, eine Mehrzahl von Konfigurationsparametern (78) des Verstärkermoduls (20) zu speichern, wenn das Verstärkermodul (20) nicht von einer externen Stromversorgung (16) bestromt ist;
wobei ein Teil der Mehrzahl von Konfigurationsparametern (78) eine Linearisierungskurve des Linearisierers des Verstärkermoduls (20) beschreibt;
wobei die Steuerung ausgeführt ist, die Mehrzahl von Konfigurationsparameter (78) während der Betriebszeit des Verstärkermoduls im Orbit zu überwachen und festzustellen, ob eine Änderung der Mehrzahl von Konfigurationsparametern erfolgt, und die Mehrzahl von Konfigurationsparametern (78) vor einem Abschalten des Verstärkermoduls automatisch in dem nicht-flüchtigen Speicher (70) abzuspeichern, wenn eine Änderung festgestellt wurde;
wobei die Steuerung ausgeführt ist, die Mehrzahl von Konfigurationsparametern (78) des Verstärkermoduls in einem Konfigurationsparameterset abzuspeichern, wobei ein Konfigurationsparameterset abgespeichert und nur als Set abgerufen werden kann.

9. Verstärkermodul (20) nach Anspruch 8,
wobei die Steuerung (64) einen flüchtigen Speicher (72) umfasst.

10. Verstärkermodul (20) nach Anspruch 8 oder 9, weiter umfassend:
eine Hilfsspannungsversorgung (74), die dazu ausgeführt ist, den nichtflüchtigen Speicher (70) mit Energie zu versorgen, wenn das Verstärkermodul (20) nicht von einer externen Stromversorgung (16) bestromt ist.

11. Verstärkermodul (20) nach einem der Ansprüche 8 bis 10, weiter umfassend:
eine Telekommandoschnittstelle (66), die dazu ausgeführt ist, ein Telekommando (28) zu empfangen, das ein Abspeichern der Mehrzahl von Konfigurationsparametern (78) im nicht-flüchtigen Speicher (70) auslöst.

12. Verstärkermodul (20) nach einem der Ansprüche 8 bis 11, weiter umfassend:
wenigstens eine Reglereinheit (48), die dazu ausgeführt ist, die Verstärkereinheit (30) anzusteuern;
wobei die Steuerung (64) dazu ausgeführt ist, einen Konfigurationsparameter (78) der Reglereinheit (48) auszulesen und/oder diesen Konfigurationsparameter (78) in dem nicht-flüchtigen Speicher (70) zu speichern; und/oder wobei die Steuerung (64) dazu ausgeführt ist, einen Konfigurationsparameter (78) aus dem nicht-flüchtigen Speicher (70) auszulesen und für die Reglereinheit (48) entsprechend zu setzen.

13. Verstärkermodul (20) nach einem der Ansprüche 8 bis 12,
wobei die Steuerung (64) dazu ausgeführt ist, das Verfahren nach einem der Ansprüche 1 bis 7 auszuführen.

## Claims

1. A method for operating an amplifier module (20) of a communication satellite (10), the method comprising the steps of:
storing, by the communication satellite, a plurality of configuration parameters (78) of the amplifier module (20) in a non-volatile memory (70) that is configured to store the plurality of configuration parameters (78) when the amplifier module is not energized;
loading the plurality of configuration parameters (78) from the non-volatile memory (70) after the amplifier module (20) is energized;
configuring the amplifier module (20) in correspondence to the loaded plurality of configuration parameters (78);
verifying if the plurality of configuration parameters (78) is changed during operation time of the amplifier module in the orbit, wherein the plurality of configuration parameters (78) is automatically stored in the non-volatile memory (70) before switching of the amplifier module if a change is detected;
wherein a part of the plurality of configuration parameters (78) describes a linearization curve of a lineariser of the amplifier module (20);
wherein the plurality of configuration parameters (78) of the amplifier module is stored in a configuration parameter set, wherein a configuration parameter set can be stored and can only be retrieved as a set.

2. Method of claim 1, further comprising the steps of:
separating the amplifier module (20) from a power supply (16) of the satellite (10) after the saving of the plurality of configuration parameters (78);
connecting the amplifier module (20) to the power supply (16) prior to the loading of the plurality of configuration parameters (78).

3. Method of any one of the preceding claims, further comprising the step of:
receiving a telecommand (28) that the plurality of configuration parameters (78) is to be stored;
wherein the plurality of configuration parameters (78) is saved in the non-volatile memory (70) in response to receipt of the telecommand (28).

4. Method of any one of the preceding claims,
wherein saving of the plurality of configuration parameters (78) involves transferring a configuration area (80) from a volatile memory (72) of the amplifier module (20) to the non-volatile memory (70),
wherein loading of the plurality of configuration parameters (78) involves transferring a content of the non-volatile memory (70) to the configuration area (80).

5. Method of claim 4, further comprising the step of:
determining that at least one specific configuration parameter (78) is not transferred from the configuration area (80) to the non-volatile memory (70) in order to prevent the configuration parameter (78) in the non-volatile memory (70) from being overwritten.

6. Method of any one of the preceding claims,
wherein, in addition to the linearization curve, the plurality of configuration parameters (78) comprises a selection of the following parameters:
an adjustment of a regulator unit (48) that is configured to regulate a voltage (50, 52, 54) of a traveling wave tube (30) of a traveling wave tube module (20);
a value of a cathode voltage of the traveling wave tube (30);
a value of a Wehnelt voltage of the traveling wave tube (30);
a value (78b) of an anode voltage (50) of the traveling wave tube (30);
a value (78c) of one or more collector voltages (52) of the traveling wave tube (30).

7. Method of any one of the preceding claims,
wherein a linearization curve (78a) of a lineariser (46) of a traveling wave tube module (20) is stored as a part of the plurality of configuration parameters (78).

8. Amplifier module (20) for a communication satellite (10), the amplifier module comprising:
an amplifier unit (30);
a lineariser; and
a control unit (64) configured to drive the amplifier unit (30);
wherein the control unit (64) comprises a non-volatile, writable memory (70) that is configured to store a plurality of configuration parameters (78) of the amplifier module (20) when the amplifier module (20) is not energized by an external power supply (16);
wherein a part of the plurality of configuration parameters (78) describes a linearization curve of the lineariser of the amplifier module (20);
wherein the control unit is configured to monitor the plurality of configuration parameters (78) during the operation time of the amplifier module in the orbit, and to verify if the plurality of configuration parameters (78) is changed, and to automatically store the plurality of configuration parameters (78) in the non-volatile memory (70) before switching of the amplifier module if a change is detected;
wherein the control unit is configured to store the plurality of configuration parameters (78) of the amplifier module in a configuration parameter set, wherein a configuration parameter set can be stored and can only be retrieved as a set

9. Amplifier module (20) of claim 8,
wherein the control unit (64) comprises a volatile memory (72).

10. Amplifier module of claim 8 or 9, further comprising:
an auxiliary voltage supply (74) configured to supply the non-volatile memory (70) with energy when the amplifier module (20) is not energized by an external power supply (16).

11. Amplifier module of any one of claims 8 to 10, further comprising:
a telecommand interface (66) configured to receive a telecommand (28) that initiates a store operation of the plurality of configuration parameters (78) in the non-volatile memory (70).

12. Amplifier module of any one of claims 8 to 11, further comprising:
at least one regulator unit (48) that is configured to drive the amplifier unit (30);
wherein the control unit (64) is configured to read out a configuration parameter (78) of the regulator unit (48) and/or store this configuration parameter (78) in the non-volatile memory (70); and/or
wherein the control unit (64) is configured to read out a configuration parameter (78) from the non-volatile memory (70) and to correspondingly set for the regulator unit (48).

13. Amplifier module (20) of any one of claims 8 to 12,
wherein the control unit (64) is configured to execute the method of any one of claims 1 to 7.

## Revendications

1. Procédé de fonctionnement d'un module d'amplification (20) d'un satellite de communication (10), le procédé comprenant les étapes :
mémorisation d'une pluralité de paramètres de configuration (78) du module d'amplification (20) dans une mémoire (70) non volatile, laquelle est réalisée pour mémoriser la pluralité de paramètres de configuration (78) lorsque le module d'amplification (20) n'est pas alimenté en courant ;
après une alimentation en courant du module d'amplification (20), chargement de la pluralité de paramètres de configuration (78) provenant de la mémoire (70) non volatile ;
configuration du module d'amplification (20) conformément à la pluralité chargée de paramètres de configuration (78) ;
vérification si la pluralité de paramètres de configuration (78) est modifiée pendant le temps de fonctionnement du module d'amplification en orbite, la pluralité de paramètres de configuration (78) étant automatiquement mémorisée dans la mémoire (70) non volatile avant une déconnexion du module d'amplification, lorsqu'une modification a été constatée ;
dans lequel procédé une partie de la pluralité de paramètres de configuration (78) décrit une courbe de linéarisation d'un linéariseur du module d'amplification (20) ;
dans lequel la pluralité de paramètres de configuration (78) du module d'amplification est mémorisée dans un jeu de paramètres de configuration, un jeu de paramètres de configuration pouvant être mémorisé et ne pouvant être appelé que comme jeu.

2. Procédé selon la revendication 1, comprenant en outre les étapes :
coupure du module d'amplification (20) d'une alimentation en courant (16) du satellite (10), une fois que la pluralité de paramètres de configuration (78) a été mémorisée ;
liaison du module d'amplification (20) à l'alimentation en courant (16) avant le chargement de la pluralité de paramètres de configuration (78).

3. Procédé selon l'une quelconque des revendications précédentes, comprenant en outre l'étape :
réception d'une télé-instruction (28) indiquant que la pluralité de paramètres de configuration (78) doit être mémorisée ;
dans lequel procédé la pluralité de paramètres de configuration (78) est mémorisée dans la mémoire (70) non volatile lorsque la télé-instruction (28) a été reçue.

4. Procédé selon l'une quelconque des revendications précédentes,
dans lequel une zone de configuration d'une mémoire (72) volatile du module d'amplification (20) est transmise dans la mémoire (70) non volatile dans le but de mémoriser la pluralité de paramètres de configuration (78) ;
dans lequel un contenu de la mémoire (70) non volatile est transmis dans la zone de configuration (80) dans le but de charger la pluralité de paramètres de configuration (78).

5. Procédé selon la revendication 4, comprenant en outre l'étape :
détermination qu'au moins un paramètre de configuration (78) déterminé provenant de la zone de configuration (80) n'est pas transmis dans la mémoire (70) non volatile, afin d'empêcher une surinscription du paramètre de configuration dans la mémoire (70) non volatile.

6. Procédé selon l'une quelconque des revendications précédentes,
dans lequel la pluralité de paramètres de configuration (78), outre la courbe de linéarisation, présente une sélection constituée des paramètres suivants :
un réglage d'une unité de régulation (48) qui est réalisée pour régler une tension (50, 52, 54) d'un tube à ondes progressives (30) d'un module de tube à ondes progressives (20) ;
une valeur d'une tension de cathode du tube à ondes progressives (30) ;
une valeur d'une tension Wehnelt du tube à ondes progressives (30) ;
une valeur (78b) d'une tension d'anode (50) du tube à ondes progressives (30) ;
une valeur (78c) d'une ou de plusieurs tensions de collecteur (52) du tube à ondes progressives (30).

7. Procédé selon l'une quelconque des revendications précédentes,
dans lequel une courbe de linéarisation (78a) d'un linéariseur (46) d'un module de tube à ondes progressives (20) est mémorisée comme partie de la pluralité de paramètres de configuration (78).

8. Module d'amplification (20) pour un satellite de communication (10), comprenant :
une unité d'amplification (30) ;
un linéariseur ; et
une commande (64) destinée à commander l'unité d'amplification (30) ;
dans lequel module d'amplification la commande (64) comprend une mémoire (70) inscriptible, non volatile, laquelle est réalisée pour mémoriser une pluralité de paramètres de configuration (78) du module d'amplification (20) lorsque le module d'amplification (20) n'est pas alimenté en courant par une alimentation électrique (16) externe ;
dans lequel une partie de la pluralité de paramètres de configuration (78) décrit une courbe de linéarisation du linéariseur du module d'amplification (20) ;
dans lequel la commande est réalisée pour surveiller la pluralité de paramètres de configuration (78) pendant le temps de fonctionnement du module d'amplification en orbite et pour constater si une modification de la pluralité de paramètres de configuration a lieu, et, avant une déconnexion du module d'amplification, pour mémoriser la pluralité de paramètres de configuration (78) automatiquement dans la mémoire (70) non volatile lorsqu'une modification a été constatée ;
dans lequel la commande est réalisée pour mémoriser la pluralité de paramètres de configuration (78) du module d'amplification dans un jeu de paramètres de configuration, un jeu de paramètres de configuration pouvant être mémorisé et ne pouvant être appelé que comme jeu.

9. Module d'amplification (20) selon la revendication 8,
dans lequel la commande (64) comprend une mémoire (72) volatile.

10. Module d'amplification (20) selon la revendication 8 ou 9, comprenant en outre :
une alimentation électrique auxiliaire (74) qui est réalisée pour alimenter en énergie la mémoire (70) non volatile lorsque le module d'amplification (20) n'est pas alimenté en courant par une alimentation électrique (16) externe.

11. Module d'amplification (20) selon l'une quelconque des revendications 8 à 10, comprenant en outre :
une interface de télé-instruction (66) qui est réalisée pour recevoir une télé-instruction (28), laquelle déclenche une mémorisation de la pluralité de paramètres de configuration (78) dans la mémoire (70) non volatile.

12. Module d'amplification (20) selon l'une quelconque des revendications 8 à 11, comprenant en outre :
au moins une unité de régulation (48) qui est réalisée pour commander l'unité d'amplification (30) ;
dans lequel la commande (64) est réalisée pour lire un paramètre de configuration (78) de l'unité de régulation (48) et/ou pour mémoriser ce paramètre de configuration (78) dans la mémoire (70) non volatile ; et/ou
dans lequel la commande (64) est réalisée pour lire un paramètre de configuration (78) de la mémoire (70) non volatile et pour l'appliquer de manière correspondante pour l'unité de régulation (48).

13. Module d'amplification (20) selon l'une quelconque des revendications 8 à 12,
dans lequel la commande (64) est réalisée pour exécuter le procédé selon l'une quelconque des revendications 1 à 7.
